# EUROPEAN PATENT APPLICATION

(11) **EP 1 764 631 A1**
(43) Date of publication of application: **21.03.2007**
(21) Application number: 05020224.1
(22) Date of filing: 16.09.2005
(51) Int. Cl.: G01T 1/203, C09K 11/77, C01F 17/00

(54) **High light yield fast scintillator**

(71) Applicant: Stichting voor de Technische Wetenschappen, 3527 JP Utrecht (NL); UNIVERSITE DE BERNE, CH-3012 Berne (CH)
(72) Inventor: The designation of the inventor has not yet been filed
(74) Representative: Colombier, Christian

(57) **Abstract**

The invention concerns a material comprising a compound of formula Pr_{(1-x-y)}Ln_{y}CeₓX₃ wherein
- Ln is chosen from the elements or mixtures of at least two elements, of the group: La, Nd, Pm, Sm, Eu, Gd, Y,
- X is chosen from the halides or mixtures of at least two halides, of the group: Cl, Br, I,
- x is above 0.0005 and is lower than 1,
- y is from 0 to 0.9 and
- (x+y) is less than 1,

and its use as scintillation detector.

## Description

The invention pertains to new scintillating materials, in particular in the form of single crystals, a process to manufacture them as single crystals, and their use to detect and/or identify X-ray and/or gamma-ray radiations.

Scintillation materials are largely used for detection of gamma-rays, X-rays, cosmic rays and particles or electromagnetic waves of lower energies down to 1 keV or lower, below designated generically as "radiation".

The scintillation mechanisms rely on a number of physical principles which essentially convert the high energy of the incoming photons or particles into light which is within or reasonably close to the visible range, so it can be detected by standard photo-detectors. Of particular interest are single crystal forms of scintillators, i.e. pieces that are at the scale of use constituted of one (at most a few) crystals. A single crystal (monacrystal) configuration allows easier extraction of the emitted light over thick dimensions thanks to the lack of internal diffusion through grain boundaries, heterogeneities and other defects that tend to be present in polycrystalline materials. A crystalline structure (in the atomic sense) is required as it determines the scintillation mechanisms: a glassy, amorphous state of matter is likely to yield different scintillation properties. The extracted light is then collected with various devices well known to the man of the art, like photomultiplier tubes, photodiodes etc. Another configuration is to still retain the crystalline structure of the material, and use it in powder form, either packed or sintered or mixed with a binder in a way that still alows light extraction. Usually, those configurations are too opaque when more than a few millimeters thick, a thickness which may not be sufficient to stop enough incoming particles or photons. Overall, whenever possible and cost effective, single crystals are preferred.

Radiation detection is of major interest in a host of applications in nuclear medicine, fundamental physics, industrial gauging, baggage scanners, oil well logging etc. In those applications, it is often desirable to discriminate at a high counting rate radiations that may also reach the detector and a scintillation detector should be able to produce different luminescence signals depending on the type of radiation (see G. F. Knoll. Radiation Detection and Measurements (Wiley, New York, 2000)).

Several criteria are needed to constitute a good X-ray or gamma-ray detector.

In a way well know to the man in the field, an energy spectrum of the scintillator under incoming radiation is drawn, whereby events are represented on a histogram (with energies on the x-axis, the number of counts on the y-axis). In the acquisition protocol, "channels" are defined to collect the signal within a particular energy range.

Good (low) energy resolution is necessary for good energy peak identification of the incoming radiation. Energy resolution is usually determined for a given detector at a given energy as the full width at half maximum of the peak considered on an energy spectrum, divided by the energy at the centroid of the peak (see G.F Knoll, "Radiation Detection and Measuremenft", John Wiley and Sons, Inc, 2nd edition, p 114).

Another very important parameter is the decay time constant, which is described in particular by W.W Moses (Nucl. Instr and Meth. A336 (1993) 253). Fast decay times allow fast analyses. In general, the time spectrum of the collected signal from a scintillator under radiation can be fitted by a sum of exponentials characterized each by a decay time constant. The quality of a scintillator is determined essentially by the contribution of the fastest emission component. This is the number we report further in the text.

A family of known scintillator crystals widely used is of the thallium-doped sodium iodide TI:Nal type. This scintillating material, discovered in 1948 by Robert Hofstadter and which forms the basis of modem scintillators, still remains the predominant material in this field in spite of almost 60 years of research on other materials. However these crystals have a scintillation decay which is not very fast.

One family of scintillator crystals that has undergone considerable development is of the bismuth germanate (BGO) type. The crystals of the BGO family have high decay time constants, which limit the use of these crystals to low count rates.

Recently, scintillating materials have been disclosed by O. Guillot-Noël et al. ("Optical and scintillation properties of cerium-doped LaCl3, LuBr3 and LuCl3" in Journal of Luminescence 85 (1999) 21-35). This article describes the scintillation properties of cerium-doped compounds such as LaCl₃ doped with 0.57 mol% Ce; LuBr₃ doped with 0.021 mol%, 0.46% mol% and 0.76 mol% Ce; LuCl₃ doped with 0.45 mol% Ce. These scintillating materials have quite useful energy resolutions, of the order of 7%, and decay time constants of the fast scintillation component that are fairly low, especially between 25 and 50 ns. However the intensity of the fast component of these materials is low, especially of the order of 1000 to 2000 photons per MeV, which means that they cannot be used as a component of a high-performance detector.

The present invention pertains to a new material containing praseodymium halide and cerium halide showing a remarkably low decay time (often written τ). The material of the invention comprises a compound of formula Pr_{(1-x-y)}Ln_{y}CeₓX₃, wherein
- Ln is chosen from La, Nd, Pm, Sm, Eu, Gd, Y or a mixture of at least two of them (La, Nd, Pm, Sm, Eu, Gd, Y),
- x is above 0,0005 and lower than 1 ;
- x is preferably above 0.005 ;
- x is preferably less than 0.9 (= less than 90 mol %) and preferably less than 0.4 :

- X is chosen from the halides Cl, Br, I or mixtures of at least two halides of the group: Cl, Br, I,
- y can be 0 and goes from 0 to 0.9 and is preferably less than (1-x)/2,
- (x+y) is less than 1.

Preferably, if X is I (Iodine) or a mixture of halides containing 50 mol% or more of the halide I, Ln is chosen from the group: La, Nd, or a mixture of both. Preferably, if X is containing less than 50 mol % of the halide I (Iodine), Ln is chosen from the group: La, Nd, Pm, Sm, Eu, Gd, Y or a mixture of at least two of them.

Present invention concerns more in particular the material consisting essentially of the compound of formula Pr_{(1-x-y)}Ln_{y}CeₓX₃ and more particularly the material consisting of the compound of formula Pr_{(1-x-y)}Ln_{y}CeₓX₃.

The compound Pr₍₁₋ₓ₎CeₓX₃ (wherein x and X have the same signification than explained above, and y is 0) is more particularly concerned.

The value x is the molar level of substitution of Pr by cerium, subsequently called "cerium content". The value x is above 0.0005, but it can also be said that x is above 0.05 mol%. Both wordings are equivalent. As an example, if x is 0.05 and y is 0, the concerned compound can be written: PrBr₃:5%Ce. Such wording is well used by the man skilled in the art.

The value y is the molar level of substitution of Pr by Ln.

An inorganic scintillating material according to the invention substantially consists of Pr₍₁₋ₓ₎CeₓX₃ and may also comprise impurities usual in the technical field of the invention. In general, the usual impurities are impurities coming from the raw material whose content is in particular less than 1 mol%, or even less than 0.1mol% (case of solubilized impurities). In case of unwanted phases, the volume percentage of these unwanted phases is especially less than 1%.

The scintillating material of the invention can be manufactured under the form of a monocristal. In this case, its volume is generally at least 10 mm³. The material can also be used in the form of a powder (polycristalline), possibly either packed or sintered or mixed with a binder.

The compounds in the examples were grown as single crystals by the vertical Bridgman technique. Because the compounds are hygroscopic the experiments were performed on samples sealed in quartz ampoules. Other known techniques to the man in the field of crystal growths could be used such as Czochralski or Kyropoulos techniques, provided the material is reasonably protected from reaction with water and oxygen. The single crystal samples in the examples were about 10 mm³ in volume.

The properties of PrBr₃:Ce³⁺ are given in Table 1 below, along with those of the scintillators already known in the field of gamma-ray detection.

**Table 1: Comparative properties of PrBr₃:Ce³⁺ and other gamma-ray scintillators,**

| Compound | LY | R | τ | density | λₑₘ |
|---|---|---|---|---|---|
| | (ph/MeV) | (%) | (ns) | | (nm) |
| PrBr₃:5%Ce | 16000 | 5.5 | 10 | 5.3 | 370 |
| PrBr3:20%Ce | 21000 | 6.9 | 10 | 5.3 | 390 |
| LaCl₃:10%Ce | 45000 | 4 | 28 | 3.9 | 350 |
| LaBr₃:5%Ce | 60000 | 2.8 | 16 | 5.3 | 380 |

The following abbreviations were used in table 1:
- LY = Light yield
- R = energy resolution
- τ = decay time
- λₑₘ = wavelength of the main peak of light emission
- 5%Ce means that x=0.05 in the generic formula which is in fact Pr_{0.95}Ce_{0.05}Br₃.

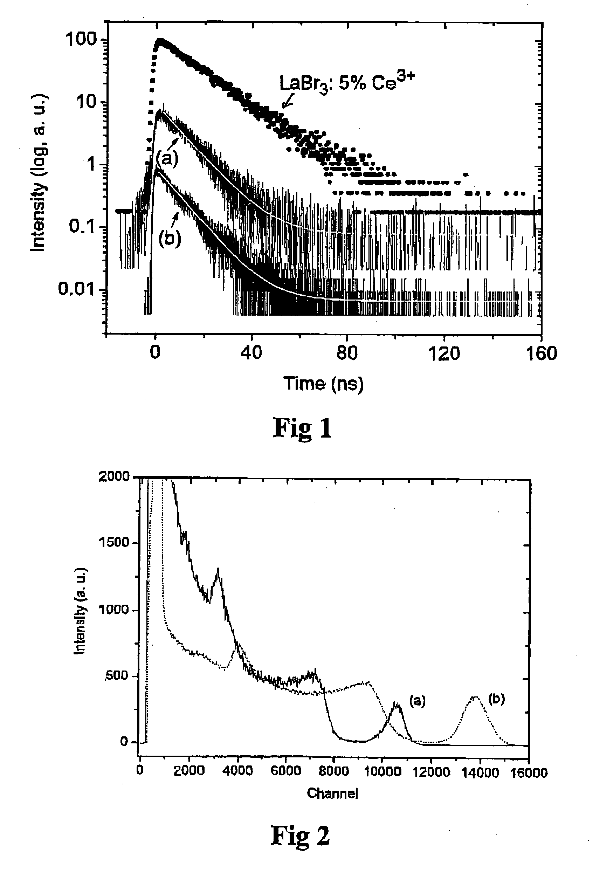

Scintillation decay time spectra of PrBr₃: 5% Ce³⁺ and PrBr₃: 20% Ce³⁺ recorded at room temperature under 137Cs γ-ray excitation using single-photon-counting techniques are shown in Figure 1. On this figure, the Scintillation decay curves at room temperature of (a) PrBr₃: 5% Ce³⁺ and (b) PrBr₃: 20% Ce³⁺ can be seen. These spectra were recorded using a single-photon counting technique. Solid lines through the data are single exponential fits. For comparison, the scintillation decay spectrum of LaBr₃:5% Ce³⁺ is also plotted.

The fast component reported for the 5 mol% cerium-doped PrBr₃ represents 90% of the emitted light, a very high number that increases the advantage of the scintillator material over other gamma-ray detectors with respect to its fast component.

Figure 2 shows pulse height spectra of radiation from a ¹³⁷Cs source recorded with (a) PrBr₃: 5% Ce³⁺ and (b) PrBr₃: 20% Ce³⁺ for 662 keV γ-rays.

It is known to the man skilled in the art that the scintillation properties of a crystal are tightly related to its structure (known as "space group"). It is also known to the man skilled in the art that crystals having the same space group can easily mix and form a crystalline solid solution. The space group of PrCl₃ and of PrBr₃ is P6₃/m. This is the same space group as for LaX₃, CeX₃, NdX₃, PmX₃, SmX₃, EuX₃ and GdX₃, with X: Cl or Br or a mixture of both. The space group of Prl₃ is Cmcm. This is the same space group as for Lal₃, Cel₃, Ndl₃.

It is shown in particular that materials of the invention constitute interesting gamma detectors, less bright than the LaBr₃:Ce known in the field of gamma detection, with a poorer energy resolution but much faster decay.

Such very fast decay is of particular interest for high count rate applications, where the number of incoming photons to be detected is extremely high, above 100 kilocounts per second (kcps), or even above 1 Mcps. This is of particular interest but not exclusively in spectroscopic analyses (where a sample is intentionally bombarded by a high flux of X-rays), or in PET scanners (Positron Tomography Emission). PET scanners with Time of Flight capabilities, which require extremely fast timing properties, could advantageously use the product of the invention,

Thus, present invention concerns also a scintillation detector (scintillator) containing the material of the invention.

## Claims

1. Material comprising a compound of formula Pr_{(1-x-y)}Ln_{y}CeₓX₃, wherein
- Ln is chosen from the elements or mixtures of at least two elements, of the group: La, Nd, Pm. Sm, Eu, Gd, Y,
- X is chosen from the halides or mixtures of at least two halides, of the group: Cl, Br, I,
- x is above 0.0005 and is lower than 1,
- y is from 0 to 0.9 and
- (x+y) is less than 1.

2. Material according to preceding claim, wherein y is less than (1-x)/2.

3. Material according to either of preceding claims, wherein x is above 0.005.

4. Material according to either of preceding claims, wherein x is less than 0.9.

5. Material according to preceding claim, wherein x is less than 0.4.

6. Material according to either of preceding claims, wherein it consist essentially of the compound of formula Pr_{(1-x-y)}Ln_{y}CeₓX₃.

7. Material according to either of preceding claims, wherein it consist of the compound of formula Pr_{(1-x-y)}Ln_{y}CeₓX₃.

8. Material according to either of preceding claims, wherein y is 0.

9. Material according to either of preceding claims, wherein X is I (Iodine) or a mixture of halides containing 50 mol % or more of the halide I and Ln is chosen from the group: La. Nd, or a mixture of both.

10. Material according to either of claims 1 to 8, wherein X is containing less than 50 mol % of I (Iodine).

11. Material according to either of preceding claims, wherein it is under the form of a monocristal.

12. Material according to preceding claim, wherein the volume of the monocristal is at least 10 mm³.

13. Material according to either of claims 1 to 10, wherein it is under the form of a powder.

14. Material according to preceding claim, wherein it is either packed or sintered or mixed with a binder.

15. Scintillator containing the material of either of preceding claims.

16. Use of a material according to either of claims 1 to 14 in gamma and / or X-ray and/or cosmic rays detection.

17. Use of material according to preceding claim, with count rates of more than 100 kcps.
